# EUROPEAN PATENT SPECIFICATION

(11) **EP 0 229 698 B1**
(45) Date of publication and mention of the grant of the patent: **17.03.1993**
(21) Application number: 87300187.9
(22) Date of filing: 09.01.1987
(51) Int. Cl.: H03M 13/00, G06F 11/10

(54) **Decoder for product codes and method of decoding such codes**
Dekoder für Produkt-Kodes und Verfahren zur Dekodierung dieser Kodes
Décodeur pour codes de multiplication et méthode pour décoder ces codes

(30) Priority: 10.01.1986 JP 3147/86; 24.01.1986 JP 13553/86
(43) Date of publication of application: 22.07.1987
(73) Proprietor: SONY CORPORATION, Tokyo 141 (JP)
(72) Inventor: Sako, Yoichiro c/o Patent Division, Shinagawa-ku Tokyo 141 (JP); Yamamura, Shinichi c/o Patent Division, Shinagawa-ku Tokyo 141 (JP)
(74) Representative: Pilch, Adam John Michael

(56) References cited:
- EP-A- 0 129 324
- EP-A- 0 156 440
- DE-A- 2 048 365
- IBM TECHNICAL DISCLOSURE BULLETIN, vol. 22, no. 6, November 1979, pages 2365-2368, New York, US; C.L. CHEN: "High-speed cyclic redundancy checking scheme for error correcting codes"
- PATENT ABSTRACTS OF JAPAN, vol. 5, no. 95 (E-62)[767], 20th June 1981; & JP-A-56 37 748 (MITSUBISHI DENKI K.K.) 11-04-1981
- PATENT ABSTRACTS OF JAPAN, vol. 9, no. 177 (P-375)[1900], 23rd July 1985, page 49 P 375; & JP-A-60 50 669 (HITACHI SEISAKUSHO K.K.) 20-03-1985; & US-A-4 698 810 (06-10-1987); & NL-A-8 402 616 (18-03-1985)

## Description

This invention relates to error correction of data, and in particular to decoders for product codes and methods of decoding such codes.

In order to detect and correct an error which has occurred in data when the date is transmitted along a transmission path or recorded on a recording medium, it is known to add an error correcting code and an error detecting code to the data that is to be transmitted or recorded. According to this technique, an error correcting code, such as a b-adjacent code, a Reed Solomon code or the like, to be used to correct data errors occurring in a predetermined quantity of transmitted or recorded data, is generated and then added to the predetermined quantity of data to be transmitted or recorded. An error detecting code is then generated from the error correcting code and the predetermined quantity of data to be transmitted or recorded. The data is added to the thus-generated error correcting code and the error detecting code, and the sum is supplied to the transmission path or the recording medium.

The data with the error correcting code and the error detecting code which is received via the transmision path or is reproduced from the recording medium undergoes the following data processing to correct a possible error which may appear therein. Specifically, the possible errors in both the data received and the error correcting codes added to this data are checked by using the error detecting code. When a data error is detected by means of the above-mentioned checking process, the error is corrected by using the aforementioned error correcting code. In other words, the error detecting code in this case is used to check for the existence of an error in the received data before the data is subsequently error-corrected.

Further, a so-called product code has previously been proposed to correct possible errors in the data. In forming this product code, a predetermined quantity of data is arranged in a rectangular array and error correcting codes are generated for the data in row and column directions of the rectangular array. The known Reed Solomon code can be employed as this error correcting code, by way of example. The above-mentioned data and error correcting codes are transmitted sequentially along the transmission path or to the recording medium in a predetermined order. The data with the error correcting code which has been received via the transmission path or from the recording medium is arranged once again in a rectangular array, and each error correcting code generated for the data in the row and column directions of the rectangular array is used to correct possible data errors.

Previously-proposed systems of this type have at least two drawbacks which will be discussed in greater detail hereinafter. Firstly, it is possible that further errors may be introduced during error correction or that not all of the errors are corrected. In the above-described previously-proposed systems, error detection is done before error correction. A second problem of some systems of this kind is that the processing time for generating the error detecting code is too long.

European Patent Application No. EP-A-0 156 440 and European Patent Application No. EP-A-0 129 324 describe prior art error correction and detection systems.

According to a first aspect of this invention there is provided a decoder for decoding a product code which is formed from a predetermined quantity of data, an error correcting code for correcting possible errors in said predetermined quantity of data, and an error detecting code for detecting possible errors in said predetermined quantity of data, said decoder comprising:
error correcting means for correcting said possible errors in said predetermined quantity of data and in said error detecting code on the basis of said product code; and
error detecting means operable to receive the predetermined quantity of error corrected data from said error correcting means and to check for possible errors in said predetermined quantity of error corrected data by using said error detecting code;
said decoder being characterised by:
means for ending the error correction processing of said possible errors by said error correcting means in response to an external data request signal;
said error detecting means being operable to receive the predetermined quantity of error corrected data from said error correcting means in response to said data request signal; and
means for outputting said predetermined quantity of error checked data when no errors are detected by said error detecting means. According to a second aspect of this invention there is provided a method of decoding a product code which is generated for correcting possible errors in a predetermined quantity of data associated with an error detecting code for detecting possible errors in said predetermined quantity of data, the method comprising the steps of:
correcting said possible errors in said predetermined quantity of data and said error detecting code on the basis of said product code; and
error-checking by using said error detecting code associated with said predetermined quantity of error corrected data;
the method being characterised by:
ending the error correction process in response to an external data request signal;
carrying out the error-checking step upon receipt of said data request signal; and
outputting said predetermined quantity of error corrected data when no error is detected.

Preferred embodiments of this invention, to be described in greater detail hereinafter, provide a decoder which is suitable for error correcting digital signals.

An error detecting code for detecting a possible error in a predetermined quantity of data to be transmitted or recorded is generated and then added to such data. In order that the sum of this data and the error detecting code may just form a rectangular array, the quantities of this data and the error detecting code are firstly determined. This data with the error detecting code is then arranged in a rectangular array and the error correcting codes are generated for the data in the row and column directions of the rectangular array thereby to form a so-called product code.

When this product code is formed, the data of each row in the row direction of the rectangular array is supplied sequentially to an error correcting code generator so as to generate an error correcting code for every row. At the same time, the data of each row is supplied sequentially to an error detecting code generator. When the last digit of the predetermined quantity of data to be transmitted or recorded is supplied to the error detecting code generator, a unique error correcting code is generated. The data in the last row of the rectangular array and the error detecting code which is located in the last row of the rectangular array are then supplied to the error correcting code generator thereby to generate a last error correcting code in the row direction. When the decoding is carried out by using the product code, the error correction process is ended in response to the acceptance of an external data request signal. The error corrected data is then checked for data error by using the error detecting code. When no data error is detected, the error-corrected and error-checked data is output.

The decoder thus accomplishes error detection after error correction. Furthermore, the processing time for generating the error detecting code is greatly reduced because it is generated simultaneously with the error correcting code.

According to the preferred embodiments, a product code arranged in a rectangular array is formed of a data portion comprising data bytes, an error detecting code, and parity portions. A generator for the product code includes a RAM (random access memory) for storing the data and parity codes. The error detecting code is generated at the same time as the parity code, thereby reducing the processing time. The error detecting code is processed with the data to produce the parity code of the corresponding data block. A decoder for the code corrects errors on the basis of the parity codes but, upon receipt of a data request signal, error correction is interrupted and the required data is output as long as no error is detected on the basis of the error detecting code.

The invention will now be described by way of example with reference to the accompanying drawings, in which:
Figure 1 is a diagrammatic representation of the arrangement of a product code which can be used in an embodiment of the present invention;
Figure 2 is a block diagram of an error correcting code generator for co-producing an error detecting code, according to an embodiment of the present invention;
Figure 3 is a block diagram showing a decoder according to an embodiment of the present invention; and
Figure 4 is a flow chart to which reference will be made in explaining the decoding operation of the decoder shown in Figure 3.

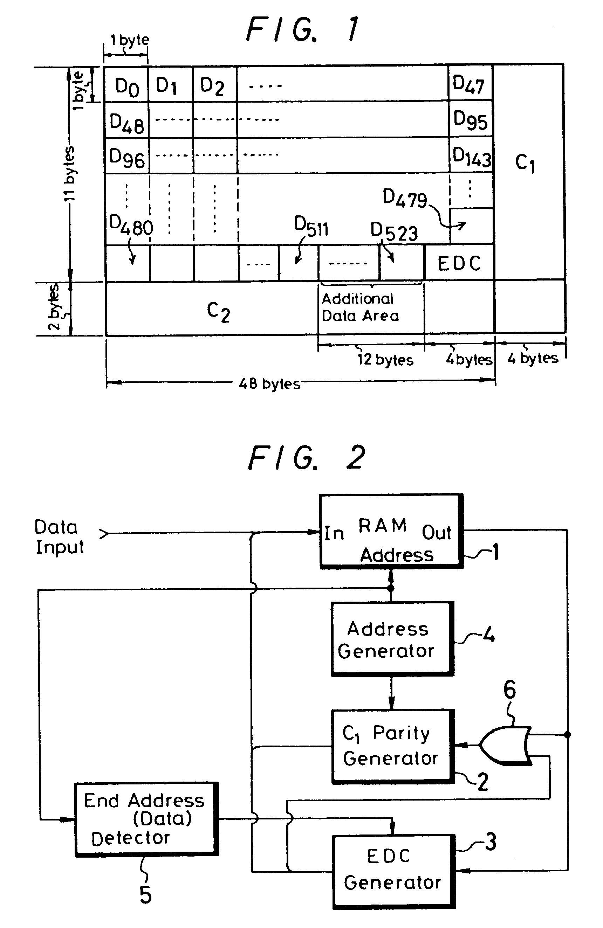

Figure 1 shows an arrangement of a product code. The quantity of product code data is chosen in consideration of the capacity of the recording medium, for example the data may be recorded on a floppy disc or magneto-optical disc used as computer mass storage. Specifically, a disc-shaped recording medium used for computer mass storage may be segmented into a plurality of sectors; for example, the standard quantity of data recorded in each sector may be selected to be 512 bytes. Accordingly, in this embodiment of the invention, 512 bytes of data is taken as the fundamental unit and the product code is formed in part by data that is an integer multiple of the fundamental data unit (512 bytes). In Figure 1, 512 bytes are selected as the quantity of data that is used to make up the product code, by way of example.

The product code shown in Figure 1 consists of a data portion and a parity portion. The data portion is formed of 512 bytes of data D₀-D₅₁₁ to be transmitted or recorded, 12 bytes of additional data D₅₁₂-D₅₂₃ that may be indicative of a track number and a sector number showing the recorded position of the 512 bytes of data on the disc-shaped recording medium, or other data identifying information and the like, and a 4-byte error detecting code EDC generated to detect possible error in the 524 bytes of total data (namely, the 512 bytes of data plus the 12 bytes of additional data). The total of 528 bytes of the data portion is arranged as a rectangular array in which the colums are formed of 11 bytes each and the rows are formed of 48 bytes each.

With respect to the row direction of this rectangular array, there is formed a first error correcting code C₁ (for example, a (52, 48) Reed Solomon code), whereas, with respect to the column direction, there is formed a second error correcting code C₂ (for example, a (13, 11) Reed Solomon code), thereby forming the parity portion of the product code. In this embodiment, after error correction of data has been carried out by using the first and second error correction codes C₁ and C₂ that in part make up the product code, possible errors in the error-corrected data are finally checked by using the error detecting code EDC. Consequently, even when an error correction has been carried out erroneously, the existing error can be detected positively by this error detecting code so that only correct data will be decoded and output.

Figure 2 is a block diagram showing an error correcting code generator for generating the aforementioned product code, and in which a generator circuit for generating the C₁ parity and a generator circuit for generating the error detecting code EDC are operated simultaneously, thereby to reduce the time required to generated the respective codes.

Referring to Figure 2, a RAM (random access memory) data buffer 1 is arranged to store the predetermined quantity of data (for example, the data D₀₋D₅₂₃ shown in Figure 1), the respective parities C₁ and C₂ generated on the basis of this data and the error detecting code EDC. A C₁ parity generator circuit 2 generates the error correcting code C₁ and an error detecting code generator 3 generates the error detecting code EDC. An address generator circuit 4 generates an address signal which is supplied to the RAM 1. An end address detector circuit 5 also receives the address signal from the address generator circuit 4 and instructs the error detecting code generator 3 to deliver the unit of data (for example, 512 bytes of data) necessary to generate the error detecting code from the RAM 1 to the error detecting code generator 3. The outputs of the RAM 1 and the error detecting code generator 3 are supplied to the C₁ parity generator circuit 2 via an OR gate 6.

With the circuit arrangement of Figure 2, the C₁ parity and the error detecting code EDC are generated as follows. On the basis of the address signal generated from the address generator circuit 4, the data making up each row of the rectangular array is read out sequentially from the RAM 1 and fed through the OR gate 6 to the C₁ parity generator circuit 2. The data forming each row of the rectangular array is also sequentially supplied directly to the error detecting code generator 3. In this embodiment, a CRC (cyclic redundancy check) code is employed as the error detecting code EDC. Alternatively, an error correcting code may be employed as the error detecting code.

The C₁ parity generator circuit 2 is supplied sequentially with the data forming each row and is arranged to generate the C₁ parity for the data that makes up the row. The C₁ parity generator circuit 2 is also supplied with the address signal from the address generator circuit 4. Hence, on the basis of the address signal supplied thereto, the C₁ parity generator circuit 2 identifies each section between the data forming the respective rows. In this way, a C₁ parity code is generated at the end of the data making up each row. The codes generated respectively by the C₁ parity generator circuit 2 and the error detecting code generator circuit 3 are stored in the RAM 1.

When the data of the last row D₄₈₀-D₅₂₃ of the rectangular data array is supplied to the error detecting code generator circuit 3, an output signal from the end address detector 5 for detecting the last data byte (D₅₂₃) causes the error detecting code generator 3 to output the error detecting code EDC and store it in the RAM 1 and also supply it through the OR gate 6 to the C₁ parity generator circuit 2. When the C₁ parity generator circuit 2 is supplied with the data used to generate the error detecting code EDC in the last row, the C₁ parity generator circuit 2 generates the last C₁ parity code for the data of the last row on the basis of this error detecting code EDC which is then supplied to the RAM 1.

In summary, as described above, in the error correcting code generator circuit, when the transmitted or recorded data and the error detecting code used to detect possible errors in this data are formed as the product code in a rectangular array, the data of each row of the rectangular array is supplied to the C₁ parity generator circuit 2 as one unit of data. The C₁ parity generator circuit 2 then generates the error correcting code to produce the C₁ parity code for the data of each row. The data of each row is simultaneously supplied in sequential order to the error detecting code generator circuit 3. When the error detecting code generator circuit 3 is supplied with the data located at the last row, the generator circuit 3 generates the error detecting code EDC. This error detecting code EDC is stored in the RAM 1 and thereby EDC. This error detecting code EDC is stored in the RAM 1 and thereby added to the transmitted or recorded data. Also, this error detecting code EDC is supplied to the C₁ parity generator circuit 2 which then generates the last C₁ parity for all of the last row data (including the error detecting code EDC). Further, although not shown in Figure 2, the C₂ parity code for the data in each column is generated by a method similar to that described with reference to the C₁ parity code.

As described above, since the C₁ parity generator circuit 2 and the error detecting code generator circuit 3 function simultaneously, the processing time for generating the error detecting code EDC can be reduced as compared with the previously-proposed systems in which the C₁ parity generator circuit and the EDC generator circuit are operated sequentially.

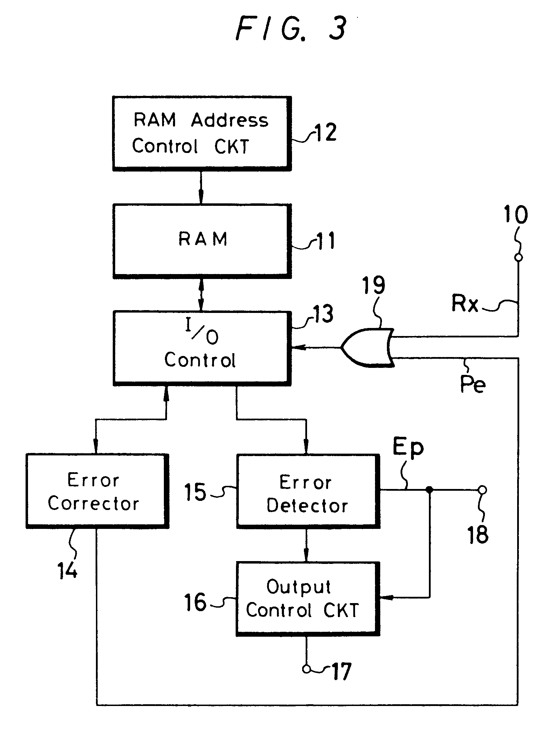

Figure 3 is a block diagram showing a decoder that is used to decode the above-mentioned product code so as to generate decoded data.

In some previously-proposed decoders, when a data request signal arrives during error correction processing, the data cannot be transmitted until the error correction processing has ended. This causes the accessing time of the data storage apparatus to become too long. The decoder of the embodiment of the present invention shown in Figure 3 decodes a product code which is formed of a predetermined quantity of data (such as 512 bytes), a data error detection code EDC, such as a cyclic redundancy check code, and an error correction code C₁ which is generated and added thereto.

As illustrated in Figure 3, the decoder is provided with an error correcting circuit 14 for error-correcting the data by using the error correcting code until an external data request signal Rx for commanding transmission of data from the decoder is applied to the decoder at a terminal 10. An error detecting circuit 15 using, for example, a CRC (cyclic redundancy check) code carries out the error detection by using the error detecting code EDC after the above-mentioned data request signal Rx has been supplied to the decoder or after the error correction by the error correcting circuit 14 has ended.

In this decoder. data reproduced from a disc-shaped medium such as a magneto-optical disc or the like is error-corrected by the error correcting code that makes up the product code, the error-corrected data is error-detected by the error detecting code EDC and then the error-corrected data is transmitted to further circuitry (not shown) such as a drive controller, a host processor or the like, in response to the external data request signal Rx. When the data request signal Rx is received by the decoder during error correction processing, the decoder is switched from the error correcting operation mode to the error detecting operation mode. In this case, the error correction processing already performed is treated as being effective. Then, a predetermined quantity of data, which is thus error-corrected at that time, is checked for error by the error detecting code EDC and the error-checked data is supplied to the drive controller, the host processor or the like (not shown) in response to the external data request signal Rx supplied to the decoder. Accordingly, it is possible for the decoder to deliver the data immediately after it has received the data request signal Rx.

Referring to Figure 3, there is provided a RAM (random access memory) 11 which stores product-coded data. This product-coded data is formed of the transmitted or recorded data D₀-D₅₂₃, an error detecting code EDC used to detect possible errors in this data and the error correcting codes C₁, C₂ that are generated for each of the row and column directions of the rectangular array formed of the above-mentioned data and the error detecting code EDC, for example as shown in Figure 1. The write address and the read address for the RAM 11 are generated from a RAM address control circuit 12. The product-coded data read out of the RAM 11 is supplied through an I/O (input/output) control circuit 13 to the error correcting circuit 14. The error correcting circuit 14 performs error correction by using the product code and the error-corrected data is then supplied from the error correcting circuit 14 back through the I/O control circuit 13 to be stored again in the RAM 11.

An error detecting circuit 15 checks for any possible errors which may be contained in the error-corrected data by carrying out a CRC code calculation using a generating polynomial. Then, the error detecting circuit 15 generates an error pulse Ep which corresponds to the presence or absence of the possible error. For instance, the error pulse Ep may become low in level when no possible error exists and become high in level when a possible error exists. This error pulse Ep is delivered to an output terminal 18 in order to request data re-transmission, and is also supplied to an output control circuit 16 in order to prevent the output control circuit 16 from sending error data via an output terminal 17.

The data which has been error-checked by the error detecting circuit 15 is delivered through the output control circuit 16 to the output terminal 17 when no error is detected. As mentioned above, the output control circuit 16 is controlled by the error pulse Ep. Accordingly, when no error is detected by the error detecting circuit 15 and the error pulse Ep is low in level, the data is delivered through the output control circuit 16 to the output terminal 17. On the other hand, when an error is detected by the error detecting circuit 15, the error pulse Ep is high in level, and the output control circuit 16 is turned off so that the data is inhibited from being transmitted and the data re-transmission request signal is formed in response to the error pulse Ep.

An error correction end signal Pe is generated from the error correcting circuit 14. This error correction end signal Pe is supplied to one input of an OR gate 19 whose other input is supplied with the data request signal Rx from the input terminal 10. The output from the OR gate 19 is supplied to the I/O control circuit 13.

The product-coded data is stored in the RAM 11 so that when the decoder starts its decoding operation, the I/O control circuit 13 is allowed to supply the product-coded data derived from the RAM 11 to the error correcting circuit 14. Thereafter, when the error correction end signal Pe is generated from the error correcting circuit 14 or the data request signal Rx is supplied through the OR gate 19 to the I/O control circuit 13, the I/O control circuit 13 is enabled to supply to the error detecting circuit 15 the error-corrected data that is stored in the RAM 11. The error detecting circuit 15 carries out the aforementioned error detecting operation and generates the error pulse Ep when an error is detected.

The decoder can switch its operation mode from the error correction mode to the error detection mode in response to the error correction end signal Pe. Alternatively, the decoder may switch its operation mode from the error correction mode to the error detection mode when the data request signal Rx is supplied thereto. When the data request signal Rx is received, even if the error correcting operation is not yet finished, the decoder switches its mode to the error detection mode. In both cases, when the error detection is carried out and no errors in the data are detected, such error free data is output at the terminal 17 and then delivered to the host processor, the drive controller or the like (not shown).

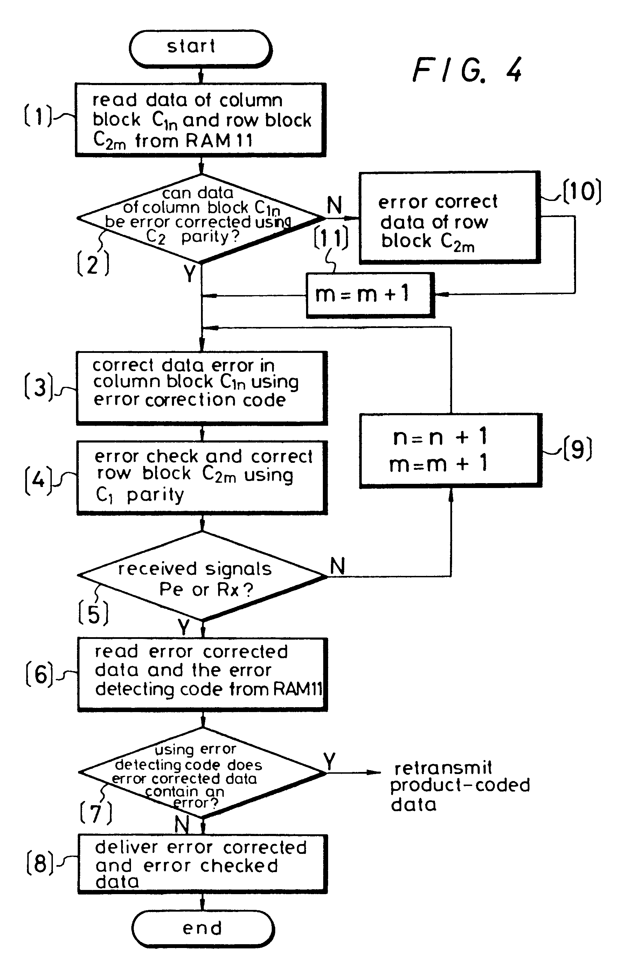

Figure 4 is a flow chart to which reference will be made in explaining one example of the decoding processing of the decoder shown in Figure 3. In the flow chart of Figure 4, Y represents "Yes" and N represents "No". Further, C₁ₙ refers to an n-th column block of the product code and C₂ₘ refers to an m-th row block of the product code, respectively. The predetermined column block C₁ₙ or the predetermined row block C₂ₘ assumes a block series from which the decoding is started. For example, if C₁ₙ is taken as the start block of the error correction processing, the data of the column block C₁ₙ and the row block C₂ₘ used for the error correction are read out from the RAM 11 at a step 1. Then, in response to the syndrome using the C2 parity, a check is performed whether or not the data of the column block C₁ₙ can be error-corrected at a step 2. When no symbol error exists or one symbol error exists, the program goes to error correction processing for the data of the column block C₁ₙ at a step 3. The error correction is carried out by using, for example, the Reed Solomon code. If no error exists, the error correction at the step 3 is not carried out.

Next, the data of the row block C₂ₘ is error-checked by using the C₁ parity. If the data contains any error, the data error is corrected at a step 4. A check is performed at a step 5 whether or not the error correction end signal Pe or the data request signal Rx has been received by the decoder. If either of the signals Pe or Rx has been received, the error correction process is finished or stopped, and the program goes to a step 6. At the step 6, the error-corrected data and the error detecting code EDC are read out of the RAM 11. Next, at a step 7, this error detecting code EDC is used to check whether or not the error-corrected data contains a possible error. If it is determined at the step 7 that a possible error exists in the error-corrected data, a signal is generated which requests that the same product-coded data be transmitted again. If, on the other hand, no error is detected at the step 7, the error-corrected data is delivered at a step 8 and the program is ended.

If it is determined at the step 5 that neither the error correction end signal Pe nor the data request signal Rx is being received by the decoder, the block numbers (n and m) are each incremented by one at a step 9, and the processing steps 3, 4 and 5 are repeatedly executed for incrementing block numbers. Accordingly, the data of the C1 block series and the C2 block series are alternately error-corrected in the sequential order of C₁ₙ, C₂ₘ, C₁ₙ₊₁, C₂ₘ₊₁,....

When it is determined at the step 2 that the data of the column block C₁ₙ, which is the decoding start series, cannot be error-corrected because it contains two or more error symbols, the data of the other row block C₂ₘ is error-corrected as the decoding start series, at a step 10. After the error correction of the data of the row block C₂ₘ at the step 10, the program goes to a step 11 at which the block number m is incremented by one. Thereafter, the program goes to the above-mentioned step 3 at which the data of the column block C₁ₙ is error-corrected. Accordingly, in this case, the data of the C1 block series and the data of the C2 block series are alternately error-corrected in the sequential order of C₂ₘ, C₁ₙ, C₂ₘ₊₁, C₁ₙ₊₁,....

It is possible to use codes other than the Reed Solomon code as the error correcting code. For example, when one symbol is formed of one bit, it is possible to employ a BCH (Bose-Chaudhuri-Hocquenghem) code. Further, codes other than the CRC code can be used as the error detecting code EDC.

## Claims

1. A decoder for decoding a product code which is formed from a predetermined quantity of data, an error correcting code (C₁) for correcting possible errors in said predetermined quantity of data, and an error detecting code (EDC) for detecting possible errors in said predetermined quantity of data, said decoder comprising:
error correcting means (14) for correcting said possible errors in said predetermined quantity of data and in said error detecting code (EDC) on the basis of said product code; and
error detecting means (15) operable to receive the predetermined quantity of error corrected data from said error correcting means (14) and to check for possible errors in said predetermined quantity of error corrected data by using said error detecting code (EDC);
said decoder being characterised by:
means (13, 19) for ending the error correction processing of said possible errors by said error correcting means (14) in response to an external data request signal (Rx);
said error detecting means (15) being operable to receive the predetermined quantity of error corrected data from said error correcting means (14) in response to said data request signal (Rx); and
means (16) for outputting said predetermined quantity of error checked data when no errors are detected by said error detecting means (15).

2. A decoder according to claim 1, wherein said error correcting code (C₁) is a Reed Solomon code.

3. A decoder according to claim 1 or claim 2, wherein said error detecting code (EDC) is a cyclic redundancy check code.

4. A decoder according to claim 1 or claim 2, wherein said error detecting code (EDC) is a Reed Solomon code.

5. A decoder according to any one of claims 1 to 4, wherein said predetermined quantity of data is 512 bytes of data.

6. A decoder according to any one of claims 1 to 5, wherein said error detecting means (15) is operable to generate a product code data re-transmission request signal (Ep) when an error is detected by said error detecting means (15) using said error detecting code (EDC).

7. A method of decoding a product code which is generated for correcting possible errors in a predetermined quantity of data associated with an error detecting code (EDC) for detecting possible errors in said predetermined quantity of data, the method comprising the steps of:
correcting (steps 1 - 3, 10, 11) said possible errors in said predetermined quantity of data and said error detecting code (EDC) on the basis of said product code; and
error-checking (steps 6, 7) by using said error detecting code (EDC) associated with said predetermined quantity of error corrected data;
the method being characterised by:
ending (step 5) the error correction process in response to an external data request signal (Rx);
carrying out the error-checking step (steps 6, 7) upon receipt of said data request signal (Rx); and
outputting (step 8) said predetermined quantity of error corrected data when no error is detected.

## Patentansprüche

1. Dekoder zum Dekodieren eines Produkt-Kodes, der aus einer vorbestimmten Menge von Daten einem Fehlerkorrektur-Kode (C₁) zum Korrigieren möglicher Fehler in der vorbestimmten Menge von Daten und einem Fehlererfassungs-Kode (EDC) zum Erfassen möglicher Fehler in der vorbestimmten Menge von Daten gebildet ist, welcher Dekoder umfaßt:
ein Fehlerkorrekturmittel (14) zum Korrigieren der möglichen Fehler in der vorbestimmten Menge von Daten und in dem Fehlererfassungs-Kode (EDC) auf der Grundlage des Produkt-Kodes und
ein Fehlerfassungsmittel (15), das wirksam ist, um die vorbesimmte Menge von fehlerkorrigierten Daten aus dem Fehlerkorrekturmittel (14) zu empfangen und um auf mögliche Fehler in der vorbestimmten Menge von fehlerkorrigierten Daten durch Benutzen des Fehlererfassungs-Kode (EDC) zu prüfen,
welcher Dekoder **gekennzeichnet** ist durch ein Mittel (13, 19) zum Beenden der Fehlerkorrekturverarbeitung der möglichen Fehler durch das Fehlerkorrekturmittel (14) in Reaktion auf ein externes Datenanforderungssignal
wobei das Fehlererfassungsmittel (15) betreibbar ist, um die vorbestimmte Menge von fehlerkorrigierten Daten aus dem Fehlerkorrekturmittel (14) in Reaktion auf das Datenanforderungssignal (Rx) zu empfangen, und
ein Mittel (16) zum Ausgeben der vorbestimmten Menge von fehlergeprüften Daten, wenn keine Fehler durch das Fehlererfassungsmitel (15) erfaßt sind.

2. Dekoder nach Anspruch 1, bei dem der Fehlerkorrektur-Kode (C₁) ein Reed Solomon-Kode ist.

3. Dekoder nach Anspruch 1 oder 2, bei dem der Fehlererfassungs-Kode (EDC) ein zyklisch redundanter Prüf-Kode ist.

4. Dekoder noch Anspruch 1 oder 2, bei dem der Fehlererfassungs-Kode (EDC) ein Reed Solomon-Kode ist.

5. Dekoder nach einem der Ansprüche 1 bis 4, bei dem die vorbestimmte Menge von Daten 512 Bytes von Daten beträgt.

6. Dekoder nach einem der Ansprüche 1 bis 5, bei dem das Fehlererfassungsmittel (15) betreibbar ist, um ein Produkt-Kodedatenrückübertragungs-Anforderungssignal (Ep) zu erzeugen, wenn ein Fehler durch das Fehlererfassungsmittel (15) erfaßt ist, das den Fehlererfassungs-Kode (EDC) benutzt.

7. Verfahren zum Dekodieren eines Produkt-Kodes, der zum Korrigieren möglicher Fehler in einer vorbestimmten Menge von Daten erzeugt wird, denen ein Fehlererfassungs-Kode (EDC) zum Erfassen möglicher Fehler in der vorbestimmten Menge von Daten zugeordnet ist, welches Verfahren Schritte umfaßt zum
Korrigieren (Schritte 1 - 3, 10, 11) der möglichen Fehler in der vorbestimmten Menge von Daten und des Fehlererfassungs-Kodes (EDC) auf der Grundlage des Produkt-Kodes und
Fehlerprüfen (Schritte 6, 7) durch Benutzen des Fehlererfassungs-Kodes (EDC), der der vorbestimmten Menge von fehlerkorrigierten Daten zugeordnet ist,
welches Verfahren **gekennzeichnet** ist durch das Beenden (Schritt 5) des Fehlerkorrekturprozesses in Reaktion auf ein externes Datenanforderungssignal (Rx),
Ausführen des Fehlerprüfschritts (Schritte 6, 7) auf den Empfang des Datenanforderungssignals (Rx) hin und
Ausgeben (Schritt 8) der vorbestimmten Menge von fehlerkorrigierten Daten, wenn kein Fehler erfaßt ist.

## Revendications

1. Décodeur destiné à décoder un code produit qui est formé à partir d'une quantité prédéterminée de données, d'un code de correction d'erreur (C₁) destiné à corriger des erreurs éventuelles dans ladite quantité prédéterminée de données et d'un code de détection d'erreur (EDC) destiné à détecter des erreurs éventuelles dans ladite quantité prédéterminée de données, ledit décodeur comprenant :
un moyen de correction d'erreur (14) pour corriger lesdites erreurs éventuelles dans ladite quantité prédéterminée de données et dans ledit code de détection d'erreur (EDC) sur la base dudit code produit ; et
un moyen de détection d'erreur (15) qui fonctionne pour recevoir la quantité prédéterminée de données à erreurs corrigées en provenance dudit moyen de correction d'erreur (14) et pour effectuer un contrôle d'erreurs éventuelles dans ladite quantité prédéterminée de données à erreurs corrigées en utilisant ledit code de détection d'erreur (EDC) ;
ledit décodeur étant caractérisé par :
un moyen (13, 19) pour mettre fin au traitement de correction d'erreur desdites erreurs éventuelles par ledit moyen de correction d'erreur (14) en réponse à un signal de requête de données externe (Rx) ;
ledit moyen de détection d'erreur (15) pouvant fonctionner pour recevoir la quantité prédéterminée de données à erreurs corrigées en provenance dudit moyen de correction d'erreur (14) en réponse audit signal de requête de données (Rx) ; et
un moyen (16) pour émettre en sortie ladite quantité prédéterminée de données à erreurs contrôlées lorsqu'aucune erreur n'est détectée par ledit moyen de détection d'erreur (15).

2. Décodeur selon la revendication 1, dans lequel ledit code de correction d'erreur (C₁) est un code Reed Solomon.

3. Décodeur selon la revendication 1 ou 2, dans lequel ledit code de détection d'erreur (EDC) est un code de contrôle de redondance cyclique.

4. Décodeur selon la revendication 1 ou 2, dans lequel ledit code de détection d'erreur (EDC) est un code Reed Solomon.

5. Décodeur selon l'une quelconque des revendications 1 à 4, dans lequel ladite quantité prédéterminée de données est constituée par 512 octets de données.

6. Décodeur selon l'une quelconque des revendications 1 à 5, dans lequel ledit moyen de détection d'erreur (15) peut fonctionner pour générer un signal de requête de retransmission de données de code produit (Ep) lorsqu'une erreur est détectée par ledit moyen de détection d'erreur (15) en utilisant ledit code de détection d'erreur (EDC).

7. Procédé de décodage d'un code produit qui est généré pour corriger des erreurs éventuelles dans une quantité prédéterminée de données associées à un code de détection d'erreur (EDC) pour détecter des erreurs éventuelles dans ladite quantité prédéterminée de données, le procédé comprenant les étapes de :
correction (étapes 1-3, 10, 11) desdites erreurs éventuelles dans ladite quantité prédéterminée de données et dans ledit code de détection d'erreur (EDC) sur la base dudit code produit ; et
contrôle d'erreur (étapes 6, 7) en utilisant ledit code de détection d'erreur (EDC) associé à ladite quantité prédéterminée de données à erreurs corrigées ;
le procédé étant caractérisé par :
l'arrêt (étape 5) du processus de correction d'erreur en réponse à un signal de requête de données externe (Rx) ;
la mise en oeuvre de l'étape de contrôle d'erreur (étapes 6, 7) suite à la réception dudit signal de requête de données (Rx); et
l'émission en sortie (étape 8) de ladite quantité prédéterminée de données à erreurs corrigées lorsqu'aucune erreur n'est détectée.
